# EUROPÄISCHE PATENTANMELDUNG

(11) **EP 1 139 412 A1**
(43) Veröffentlichungstag der Anmeldung: **04.10.2001**
(21) Anmeldenummer: 00106839.4
(22) Anmeldetag: 30.03.2000
(51) Int. Cl.: H01L 21/60, H01L 23/31

(54) **Flip-chip Halbleiterbauelement mit Rückseitenkontaktierung**

(71) Anmelder: Infineon Technologies AG, 81541 München (DE)
(72) Erfinder: Schaffer, Josef-Paul, 85604 Zorneding (DE)
(74) Vertreter: Fischer, Volker, Dipl.-Ing.

(57) **Zusammenfassung**

Es ist eine Methode zur Kontaktierung eines gehäuselosen Chips (1) angegeben, der eine elektrisch aktive Vorderseite (2) und eine Rückseite (3) hat. Wie bei einer herkömmlichen Flipchip-Montage wird der Chip (1) mit seiner Vorderseite auf einen Träger (8) befestigt, beispielsweise gelötet. Es ist ein Kontaktelement (5) mit Anschlußelementen (6) vorgesehen, welches mit der Rückseite (3) des Chips (1) verbunden ist, sowie mit Anschlußelementen (6) mit dem Träger (8) verlötet ist. Neben einem geringen Flächenbedarf weist das beschriebene Prinzip den Vorteil auf, daß Chips mit aktiver Rückseite (3) in einem einfachen Lötverfahren auf einem Substrat verlötbar sind. Zusätzlich ist die Ableitung von Verlustwärme des Chips (1) verbessert.

## Beschreibung

Halbleiter-Bauelement mit einem Chip und Anordnung mit einem Chip

Die vorliegende Erfindung betrifft ein Halbleiter-Bauelement mit einem gehäuselosen Halbleiter-Chip sowie eine Anordnung mit einem gehäuselosen Halbleiter-Chip.

Normalerweise werden gehäuselose Chips entweder in Flipchip-Technik oder mittels Drahtkontaktierung (Wirebonding) auf einem Substrat kontaktiert. Während bei der Flipchip-Kontaktierung ein Halbleiterchip direkt auf einem Substrat ohne Kontaktierdrähte oder Anschlußbeinchen kontaktiert wird, werden bei der Drahtkontaktierung einzelne Drahtverbindungen vom Chip zum Substratanschluß gezogen.

Halbleiterchips weisen normalerweise eine Vorderseite und eine Rückseite auf. Unter der Vorderseite wird die Seite verstanden, welche strukturiert ist. Im allgemeinen können Halbleiterchips sowohl auf ihrer Vorderseite als auch auf ihrer Rückseite Chipanschlüsse aufweisen. Als aktive Seite wird eine Chipanschlüsse aufweisende Seite eines Halbleiter-Chips bezeichnet.

Die Flipchip-Kontaktierung hat den Vorteil, daß alle Kontakte des Chips gleichzeitig in einem Komplettlötverfahren mit entsprechenden Anschlüssen auf einem Substrat verlötbar sind. Da bei der Flipchip-Kontaktierung keine Kontaktdrähte über die Kontur des Chips hinausragen, ist der Platzbedarf bei der Flipchip-Montage sehr gering. Ein wesentlicher Nachteil dieses Kontaktierverfahrens ist jedoch, daß alle aktiven Anschlüsse des Bauteils auf seiner Vorderseite angeordnet sein müssen. Bei der Flipchip-Kontaktierung wird der Chip zur Kontaktierung umgedreht, so daß er mit seiner strukturierten Vorderseite der Leiterplatte zugewandt montiert wird (face down). Die Anschlüsse des Chips können daher nur auf seiner Vorderseite angeordnet sein. Um den Chip in Flipchip-Technik mit dem Substrat verlöten zu können, müssen auf einen oder beide Verbindungspartner schmelzfähige Höcker aufgebracht werden, die, in direkten Kontakt gebracht, aufgeschmolzen werden können und so die Verbindung herstellen. Da bei der Flipchip-Kontaktierung keine Verbindung der Chiprückseite mit dem Substrat vorgesehen ist, muß der Kühlung des Chips besondere Aufmerksamkeit gewidmet werden.

Bei einem Drahtkontaktierverfahren wird der Halbleiterchip mit der Rückseite auf ein Substrat beziehungsweise eine Leiterplatte aufgebracht. Diese Verbindung wird üblicherweise in einem Klebeverfahren oder durch ein eutektisches Legieren hergestellt. Durch Verwendung eines elektrisch leitfähigen Klebers kann die Verbindung der Chiprückseite mit dem Substrat elektrisch leitfähig ausgeführt sein. Die Anschlüsse auf der Vorderseite des Chips werden mit Kontaktierdrähten (Bonddrähten) mit dem Substrat verbunden. Vorteil des Drahtkontaktierens ist, daß die Halbleiterbauelemente sowohl Vorder- als auch Rückseiten-Anschlüsse aufweisen können. Nachteilig bei der Drahtkontaktierung ist aber die große Anzahl der Montageschritte, die hierdurch längere Montagezeit sowie die damit verbundenen höheren Kosten. Daher wird im allgemeinen die Flipchip-Montage bevorzugt.

Man kann Halbleiterchips derart gestalten, daß rückseitige Chipanschlüsse innerhalb des Bauteils zur Vorderseite des Chips durchverbunden werden und dort mittels einer Anschlußfläche kontaktierbar sind. Hierdurch können auch Bauelemente mit aktiver Vorder- und Rückseite in einem Flipchip-Verfahren montiert werden. Dieses führt jedoch zu zahlreichen Nachteilen: Die elektrischen Eigenschaften des Bauelements werden verschlechtert, da beispielsweise bei Durchverbinden des Kathodenanschlusses einer PIN-Diode oder des Kollektors eines Bipolartransistors durch den Halbleiterchip auf die Vorderseite ein nicht zu vernachlässigender parasitärer Widerstand entsteht. Darüber hinaus führt das beschriebene Verfahren zu einem erhöhten Bedarf an Chipfläche, was zu höheren Kosten führt und deshalb unerwünscht ist.

Der vorliegenden Erfindung liegt die Aufgabe zugrunde, ein Halbleiter-Bauelement mit einem Chip und eine Anordnung mit einem Chip anzugeben, welche für gehäuselose Chips geeignet sind, die sowohl auf ihrer Vorder- als auch auf ihrer Rückseite Anschlüsse haben können und welche bezüglich Flächenbedarf und thermischen Eigenschaften verbessert sind.

Bezüglich des Halbleiter-Bauelementes wird die Aufgabe mit einem Halbleiter-Bauelement gelöst, aufweisend einen Chip, der eine Vorderseite mit zumindest einem Chipanschluß hat, mit dem das Bauelement auf einem Träger befestigbar ist, wobei die Vorderseite dem Träger zugewandt ist, und der eine der Vorderseite gegenüberliegende Rückseite hat; ein Kontaktelement, welches großflächig mit der Rückseite des Chips verbunden ist, und welches zumindest ein Anschlußelement aufweist, das auf dem Träger befestigbar ist.

Bezüglich der Anordnung wird die Aufgabe mit einer Anordnung gelöst mit einem Träger; einem Chip, der eine Vorderseite mit zumindest einem Chipanschluß hat, mit dem das Bauelement auf dem Träger befestigt ist, wobei die Vorderseite dem Träger zugewandt ist, und der eine der Vorderseite gegenüberliegende Rückseite hat; und einem Kontaktelement, welches großflächig mit der Rückseite des Chips verbunden ist, und welches zumindest ein Anschlußelement aufweist, das auf dem Träger befestigt ist.

Wie bei der Flipchip-Montage wird der Chip umgedreht und mit seiner Vorderseite, welche seine strukturierte Seite ist, auf einem Träger angeordnet. An der Rückseite des Chips ist jedoch zusätzlich ein Kontaktelement angebracht, welches großflächig mit der Chiprückseite verbunden ist, und welches zumindest ein Anschlußelement aufweist, welches ebenso wie der oder die Anschlüsse an der Chip-Vorderseite mit dem Träger verbindbar ist. Da die Verbindungen zwischen Chiprückseite und Trägerelement, das Trägerelement mit seinen zumindest einen Anschlußelement sowie die Verbindungen des Anschlußelements mit dem Träger elektrisch leitfähig sein können, kann der Chip eine aktive Rückseite aufweisen, das heißt, elektrisch mit dem Träger zu verbindende Chipanschlüsse. Da das Kontaktelement mit dem Chip bereits vor der eigentlichen Montage auf einem Substrat verbunden werden kann, ist der Montageaufwand des derartigen Halbleiter-Bauelementes gegenüber einer herkömmlichen Flipchip-Montage nicht vergrößert, da jeweils lediglich ein Bauelement aus einem Vorrat entnommen, passend orientiert, positioniert und auf das Substrat aufgebracht werden muß. Wie bei der herkömmlichen Flipchip-Montage können Lothöcker entweder an entsprechenden Stellen am Substrat oder an den vorderseitigen Chipanschlüssen und den Anschlußelementen des Kontaktelementes aufgebracht werden. Neben den mit der beschriebenen Anordnung erreichbaren guten elektrischen Eigenschaften wie niedriger Widerstand und niedrige Induktivität ist bei guter thermischer Leitfähigkeit des Kontaktelements und der Verbindung von Chiprückseite und Kontaktelement eine gute Abführung der Verlustleistung, welche innerhalb des Chips im Betrieb entsteht, gewährleistet. Aufgrund der einfachen Herstellung und Verarbeitung des beschriebenen Halbleiter-Bauelement ergeben sich zusätzliche wirtschaftliche Vorteile.

In einer vorteilhaften Ausführungsform der vorliegenden Erfindung ist die Verbindung zwischen Kontaktelement und Chip-rückseite eine eutektische Verbindung. Die Verbindung zwischen Chiprückseite und Kontaktelement kann in einem Legiervorgang hergestellt werden.

In einer weiteren, vorteilhaften Ausführungsform der vorliegenden Erfindung wird die Verbindung zwischen Chiprückseite und Kontaktelement durch Kleben hergestellt. Besonders bei relativ großen Chipflächen können die aufgrund des thermischen Ausdehnungsverhaltens von Chip bezüglich Kontaktelement auftretenden thermischen Spannungen durch Kleben ausgeglichen werden. Während bei Legieren und Löten neben der mechanischen in jedem Fall auch eine elektrisch und thermisch leitende Verbindung hergestellt wird, sind beim Kleben auch elektrisch oder thermisch nicht leitende Verbindungen möglich, je nach Erfordernissen.

In einer weiteren, vorteilhaften Ausführungsform der vorliegenden Erfindung ist die Verbindung zwischen Chiprückseite und Kontaktelement eine Lötverbindung.

In einer weiteren, vorteilhaften Ausführungsform der vorliegenden Erfindung ist das Kontaktelement, welches Anschlußelemente haben kann, elektrisch leitfähig ausgeführt.

In einer weiteren, vorteilhaften Ausführungsform der vorliegenden Erfindung ist das Kontaktelement thermisch leitfähig. Das Kontaktelement kann beispielsweise aus Metall bestehen. Zum elektrischen Anschluß der Chiprückseite und zur Abführung der entstehenden Verlustwärme im Chip kann ein thermisch oder elektrisch leitfähiges Kontaktelement beispielsweise mit einem Leitkleber, der Metallteilchen enthält, verbunden werden.

In einer weiteren, vorteilhaften Ausführungsform der vorliegenden Erfindung sind an dem zumindest einen Chipanschluß sowie an dem zumindest einen Anschlußelement des Kontaktelementes Lothöcker angebracht. Hierdurch kann ein derartiges Halbleiter-Bauelement auf einem Substrat in einem Lötverfahren, beispielsweise Reflow-Verfahren, verlötet werden.

In einer weiteren, vorteilhaften Ausführungsform der vorliegenden Erfindung ist das Kontaktelement vollflächig mit der Chiprückseite verbunden. Hierdurch kann eine besonders hohe, mechanische Stabilität sowie ein gutes Abführen der im Chip entstehenden Verlustwärme ermöglicht werden.

Wenn beispielsweise die Chiprückseite zwei elektrisch voneinander getrennte Chipanschlüsse aufweist, kann zur Verbindung der rückseitigen Chipanschlüsse mit einem Träger beziehungsweise Substrat ein weiteres Kontaktelement vorgesehen sein, welches großflächig mit der Chiprückseite beziehungsweise mit dem entsprechenden, dem jeweiligen Kontaktelement zugeordneten rückseitigen Chipanschluß verbunden ist. Zur Verbindung des weiteren Kontaktelements mit dem Träger hat das Kontaktelement zumindest ein weiteres Anschlußelement.

In einer weiteren, vorteilhaften Ausführungsform der vorliegenden Erfindung können mehrere Halbleiter-Bauelemente rückseitig mit einem gemeinsamen Kontaktelement verbunden sein. Dies kann bezüglich elektrostatischer Entladungen (ESD, Electrostatic Discharge) vorteilhaft sein. Darüber hinaus kann hierdurch die Anzahl der Bestückungsvorgänge reduziert sowie die Anzahl der in einem Bestückungsvorgang auf einer Leiterplatte anzuordnenden Chips erhöht werden. Da durch Verbinden der Chiprückseiten mit dem Kontaktelement auch ein gemeinsamer elektrischer Anschluß der Chiprückseiten mit der Leiterplatte erfolgen kann, kann hierdurch auch die Zahl der erforderlichen Anschlußstellen zwischen Chips und Substrat reduziert werden.

Bei Halbleiter-Bauelementen mit einem Chip ohne elektrisch aktive Rückseite kann das Kontaktelement als Wärmesenke dienen.

Um eine Anordnung mit einem gehäuselosen Chip, der mit seiner Vorderseite einem Träger zugewandt an demselben befestigt ist, und mit einem Kontaktelement, das an der Rückseite des Chips befestigt ist, und dessen Anschlußelemente mit dem Träger verbunden sind, zu erhalten, kann entweder ein beschriebenes Halbleiter-Bauelement auf den Träger verlötet werden, oder der Chip wird zunächst auf den Träger gelötet oder geklebt, und anschließend wird das Kontaktelement mit der Chip-Rückseite und mit dem Träger verbunden. Ersteres Vorgehen hat den Vorteil, daß bei einer Bestückung des Trägers weniger Arbeitsschritte erforderlich sind, da weniger Einzelteile zu verarbeiten sind.

Weitere Einzelheiten der vorliegenden Erfindung sind in den Unteransprüchen angegeben.

Die Erfindung wird nachfolgend an mehreren Ausführungsbeispielen anhand der Zeichnungen näher erläutert.

### Es zeigen:

- Figur 1: Ein Ausführungsbeispiel eines Halbleiter-Bauelementes mit in 45°-Winkeln abgebogenen Anschlußelementen in einer Schnittdarstellung,
- Figur 2: Ein Ausführungsbeispiel eines Halbleiter-Bauelementes mit in 90°-Winkeln abgebogenen Anschlußelementen auf einer Leiterplatte in einer Schnittdarstellung,
- Figur 3: Ein Ausführungsbeispiel eines Halbleiter-Bauelementes mit abgerundeter Ausführung der Anschlußelemente auf einer Leiterplatte in einer Schnittdarstellung,
- Figur 4: Ein Halbleiter-Bauelement mit einem Kontaktelement in rotationssymmetrischer Ausführung in einer Draufsicht,
- Figur 5: Das Halbleiter-Bauelement gemäß Figur 4 in einer Schnittdarstellung,
- Figur 6: Ein Halbleiter-Bauelement gemäß Figur 4 mit mehreren vorderseitigen Anschlüssen,
- Figur 7: Ein Halbleiter-Bauelement mit rechteckförmigem Kontaktelement in einer Draufsicht,
- Figur 8: Das Halbleiter-Bauelement gemäß Figur 7 in einer Schnittdarstellung,
- Figur 9: Ein Halbleiter-Bauelement mit einem Kontaktelement und mehreren Chips in einer Draufsicht,
- Figur 10: Die Anordnung gemäß Figur 9 in einer Schnittdarstellung,
- Figur 11: Ein Halbleiter-Bauelement mit zwei Kontaktelementen in einer Draufsicht,
- Figur 12: Das Halbleiter-Bauelement gemäß Figur 11 in einer Schnittdarstellung, und
- Figur 13: Ein Halbleiter-Bauelement mit einem Kontaktelement gemäß Figur 7 und mehreren Chips gemäß Figur 9.

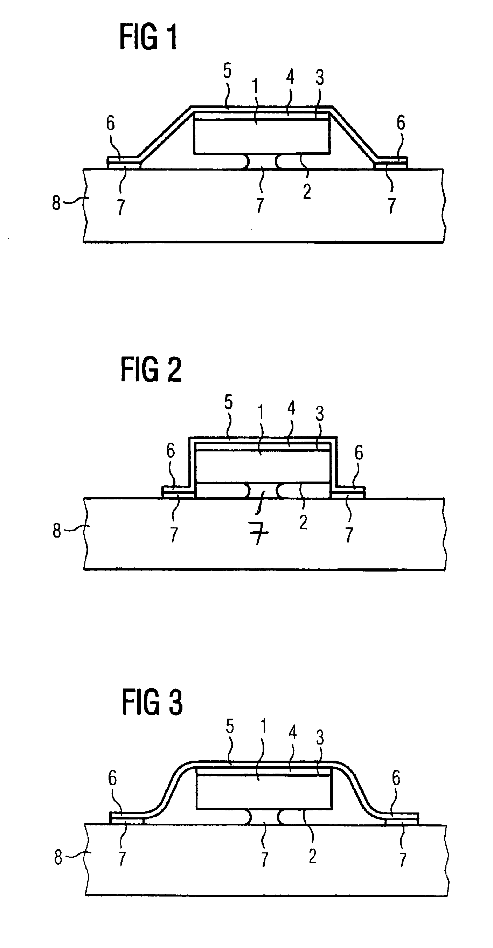

Figur 1 zeigt einen Chip 1 mit einer aktiven Vorderseite 2 und mit einer aktiven Rückseite 3. Mit einem leitfähigen Kleber 4 ist ein Kontaktelement 5 an der Rückseite 3 des Halbleiterchips 1 befestigt. Der Leitkleber 4 stellt dabei eine thermische, elektrische und mechanische Verbindung zwischen Kontaktelement 5 und Rückseite 3 her. An das Kontaktelement 5 sind Anschlußelemente 6 angeformt. Chipanschlüsse auf der Vorderseite 2 des Chips 1 und die Anschlußelemente 6 des Kontaktelementes 5 sind mit einem Träger 8 mit Lot 7 verlötbar. Vor einem Lötprozeß kann das Lot 7 in Form von Lotdepots an den zu verlötenden Anschlüssen des Halbleiter-Bauelements angeordnet sein. Der Träger 8 kann eine Leiterplatte oder ein Substrat sein. Im Ausführungsbeispiel gemäß Figur 1 sind die Anschlußelemente 6 des Kontaktelementes 5 jeweils in 45°-Winkeln bezüglich Träger 8 und Chip-Rückseite 3 abgebogen. In diesem Ausführungsbeispiel beträgt die Chipdicke ca. 140 µm und die Stärke des Lothöckers 7 an der Chip-Vorderseite 2 vor dem Verlöten ca. 100µm bis 150µm.

Figur 2 zeigt ein weiteres Ausführungsbeispiel eines Halbleiter-Bauelementes, welches demjenigen von Figur 1 entspricht, abgesehen von den hier jeweils um 90° an den Kanten der Chip-Rückseite 3 sowie an der Projektion der Chipkontur auf die Leiterplatte 8 abgebogenen Anschlußelementen. Vorteil dieser Ausführungsform ist, daß Leiterplattenfläche eingespart werden kann.

Besonders bei großen Bauelementen können verschiedene Materialien unterschiedliche Ausdehnungskoeffizienten bezüglich Erwärmung aufweisen. Um hierdurch bedingte, thermische Spannungen zu vermeiden, kann das Kontaktelement 5 mit seinen Anschlußelementen 6 abgerundet ausgeführt sein. Hierdurch können unterschiedliche Ausdehnungskoeffizienten von Kontaktelement 5, welches beispielsweise aus Metall gefertigt sein kann, und Chip 1, welcher beispielsweise ein Silizium-Einkristall sein kann, ausgeglichen werden. Abgesehen von der in Figur 3 dargestellten, abgerundeten Ausführung des Kontaktelementes 5 entspricht das Halbleiter-Bauelement den bereits beschriebenen Ausführungsbeispielen.

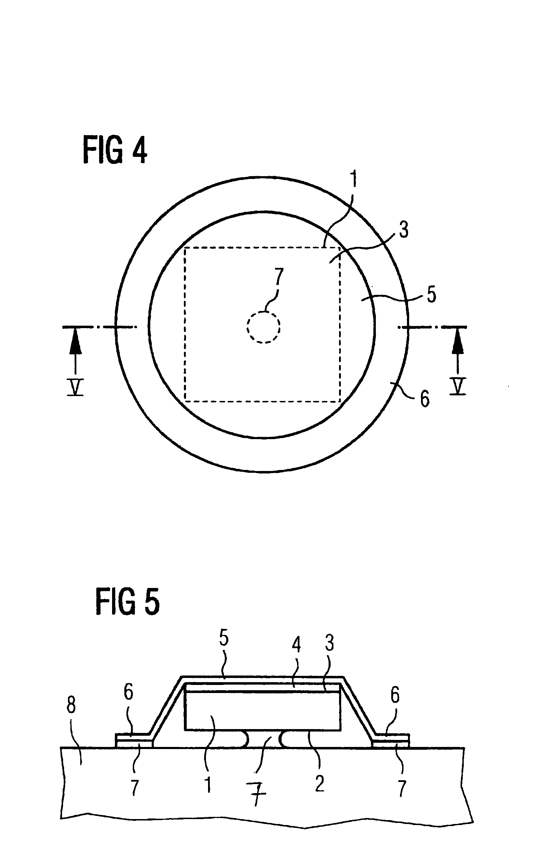

Es kann erwünscht sein, den Chip 1 bezüglich seiner Umgebung nach einem Auflöten auf einen Träger 8 hermetisch abzuschließen und bei einer Fertigung des Bauteils eine Selbstjustierung desselben zu erreichen. Hierfür kann, wie Figuren 4 und 5 zeigen, eine rotationssymmetrische Anordnung des Trägerelementes 5 ausgeführt sein. Diese Anordnung weist zusätzlich den Vorteil auf, daß die Wärmeableitung durch die großflächige Ausführung des Kontaktelementes 5 verbessert ist. Figur 5 zeigt dabei einen Schnitt durch das in Figur 4 in einer Draufsicht dargestellte Halbleiter-Bauelement.

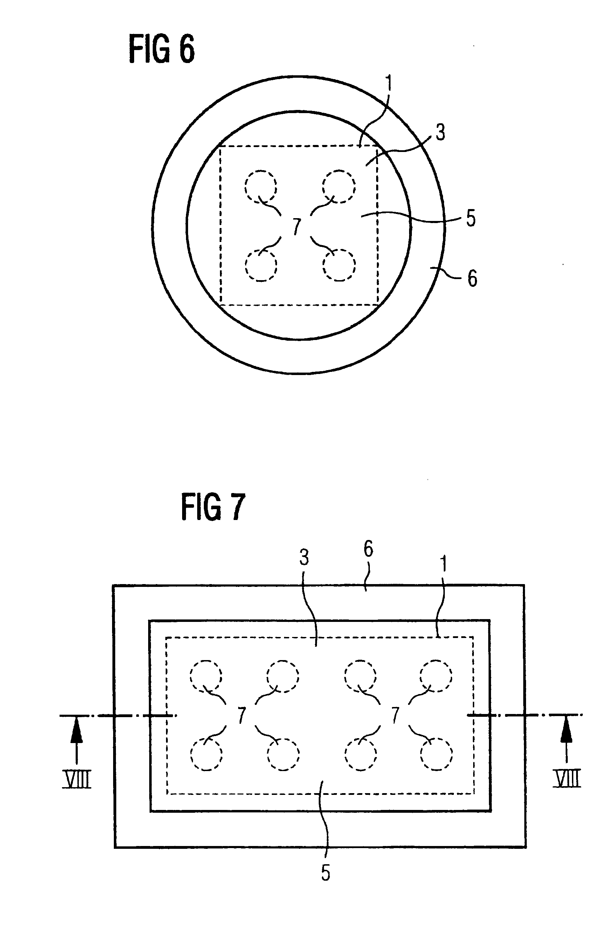

Eine Ausführungsform eines Halbleiter-Bauelementes mit rotationssymmetrischem Kontaktelement 5, bei dem der Chip 1 an seiner Vorderseite 2 mehrere Anschlußhöcker (Bumps) 7 aufweist, ist in Figur 6 dargestellt.

Figur 7 zeigt ein Ausführungsbeispiel eines Chips 1 mit rechteckförmigem Querschnitt, der von einem Kontaktelement 5 mit Anschlußelement 6, welches umlaufend rechteckförmig ausgeführt ist, bedeckt ist, in einer Draufsicht. Das Kontaktelement 5 ist dabei mit der Rückseite 3 des Chips 1 vollflächig verbunden.

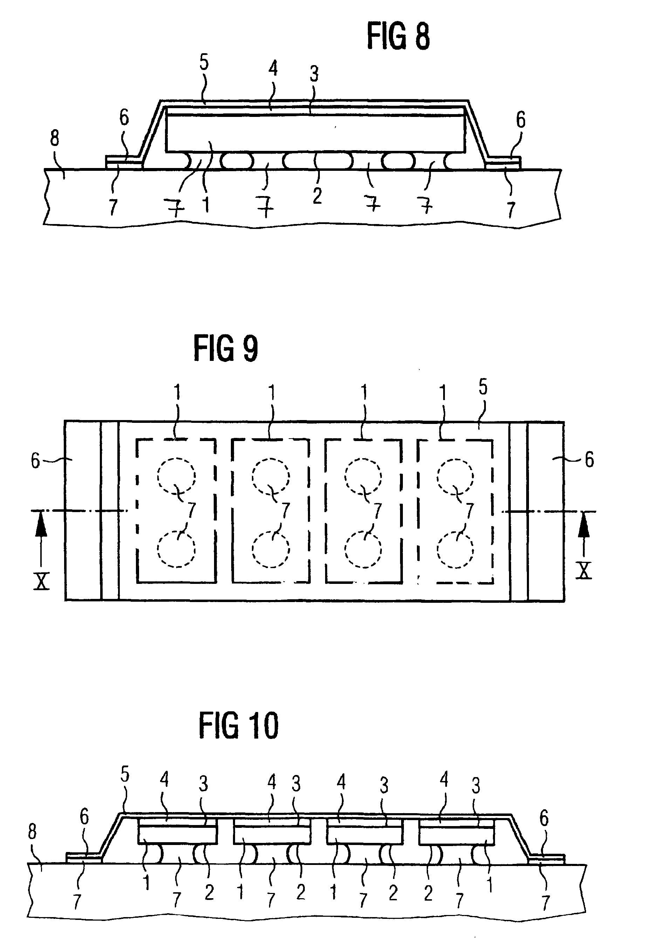

Figur 8 zeigt einen Schnitt durch das Halbleiter-Bauelement gemäß Figur 7, welches mit Lot 7 auf einer Leiterplatte 8 verlötet ist.

Bei einer in Figur 9 dargestellten Ausführungsform sind mehrere Chips 1 jeweils mit ihrer Rückseite 3 mittels Leitkleber 4 an einem Kontaktelement 5 befestigt. Dieses Kontaktelement 5 mit seinen Anschlußelementen 6 ist bügelförmig ausgeführt und ein metallischer Leiter. Figur 10 zeigt das Halbleiter-Bauelement, welches mehrere Chips 1 aufweist, in einem Querschnitt. Diese Ausführungsform ermöglicht bei Montage auf einem Träger 8 eine deutliche Platzersparnis. Durch Reduzierung der Einzel-Halbleiter-Bauelemente ist zusätzlich der Bestükkungsaufwand sowie die Bestückungszeit reduziert. Weiterhin wird die Vermeidung von Wechselwirkungen, beispielsweise elektrostatischen Wechselwirkungen, zwischen den einzelnen Chips 1 ermöglicht.

In einer in Figur 13 dargestellten Alternative mit mehreren Chips 1 an einem gemeinsamen Kontaktelement 5 kann dieses Kontaktelement 5 auch wannenförmig ausgeführt sein, analog zu dem in Figur 7 für einen Chip 1 dargestellten Kontaktelement.

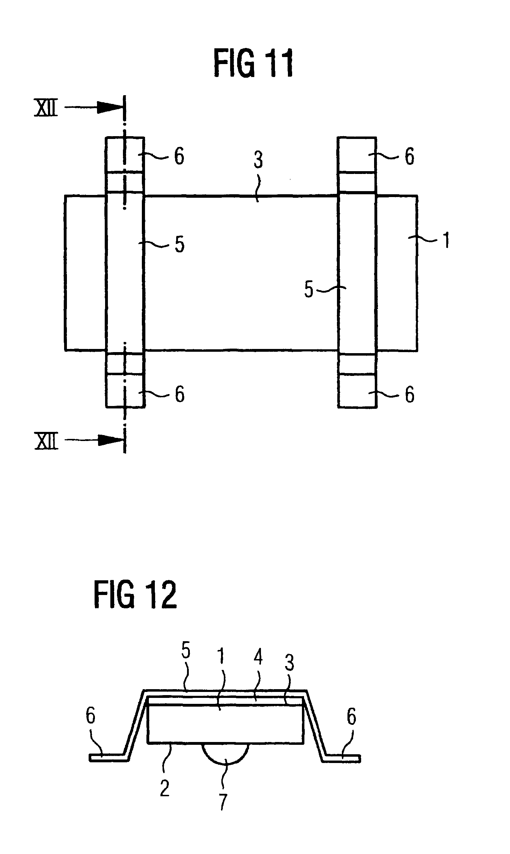

Wenn die Rückseite eines Chips 1 mehrere, elektrisch getrennte Anschlüsse aufweist, kann es sinnvoll sein, für einen Chip 1 mehrere Kontaktelemente 5 vorzusehen. Ein anderer Grund hierfür kann beispielsweise Materialersparnis sein. Zur Kontaktierung rückseitiger Chipanschlüsse weisen die Kontaktelemente 5 jeweils zumindest ein Anschlußelement 6 auf. Die Kontaktelemente 5 können an der Chiprückseite 3 beispielsweise mit einem Leitkleber 4 angebracht sein. Figur 12 zeigt das Halbleiter-Bauelement mit mehreren Kontaktelementen 5 gemäß Figur 11 in einer Schnittdarstellung. An der Chip-Vorderseite 2 ist in Figur 12 ein Lotdepot (Bump) angeordnet. Selbstverständlich können, wenn die Vorderseite des Chips mehrere Chipanschlüsse aufweist, mehrere Lothöcker 7 vorgesehen sein. Die Schnittdarstellung gemäß Figur 12 zeigt, daß bei den Chips 1, bei denen die Anschlußelemente 6 alle auf einer Linie angeordnet sind, die Bestückung einer Leiterplatte 8 mit solchen Halbleiter-Bauelementen durch Anordnen eines Kontaktelementes 5 mit Anschlußelementen 6 dadurch erleichtert und verbessert wird, daß ein auf eine Leiterplatte 8 bestücktes Halbleiter-Bauelement bereits vor einem Lötvorgang in der gewünschten Position ausrichtbar ist. Die Anschlußelemente 6 des Kontaktelements 5 können, falls elektrische und mechanische Kontaktierung gewünscht ist, ebenfalls Lothöcker 7 aufweisen, welche in Figur 12 nicht dargestellt sind. Hierdurch kann das zumindest ein Kontaktelement 5 aufweisende Halbleiter-Bauelement in einem einzigen Verfahrensschritt, beispielsweise in einem Reflow-Lötverfahren, auf eine Leiterplatte verlötet werden.

## Patentansprüche

1. Halbleiter-Bauelement, aufweisend
- einen Chip (1), der eine Vorderseite (2) mit zumindest einem Chipanschluß hat, mit dem das Bauelement auf einem Träger (8) befestigbar ist, wobei die Vorderseite (2) dem Träger (8) zugewandt ist, und der eine der Vorderseite (2) gegenüberliegende Rückseite (3) hat,
- ein Kontaktelement (5), welches großflächig mit der Rückseite (3) des Chips (1) verbunden ist, und welches zumindest ein Anschlußelement (6) aufweist, das auf dem Träger (8) befestigbar ist.

2. Halbleiter-Bauelement nach Anspruch 1,
**dadurch gekennzeichnet, daß**
die Verbindung zwischen Kontaktelement (5) und Rückseite (3) des Chips (1) eine eutektische Verbindung (4) ist.

3. Halbleiter-Bauelement nach Anspruch 1,
**dadurch gekennzeichnet, daß**
die Verbindung zwischen Kontaktelement (5) und Rückseite (3) des Chips (1) eine Klebeverbindung (4) ist.

4. Halbleiter-Bauelement nach Anspruch 1,
**dadurch gekennzeichnet, daß**
die Verbindung zwischen Kontaktelement (5) und Rückseite (3) des Chips (1) eine Lötverbindung ist.

5. Halbleiter-Bauelement nach einem der Ansprüche 1 bis 4,
**dadurch gekennzeichnet, daß**
das zumindest eine Kontakt- und Anschlußelement (5, 6) elektrisch leitfähig ist.

6. Halbleiter-Bauelement nach einem der Ansprüche 1 bis 5,
**dadurch gekennzeichnet, daß**
das Kontakt- und Anschlußelement (5, 6) thermisch leitfähig ist.

7. Halbleiter-Bauelement nach einem der Ansprüche 1 bis 6,
**dadurch gekennzeichnet, daß**
an dem zumindest einen Anschlußelement (6) sowie an dem zumindest einen Chipanschluß Lothöcker (7) angeordnet sind.

8. Halbleiter-Bauelement nach einem der Ansprüche 1 bis 7,
**dadurch gekennzeichnet, daß**
das Kontaktelement (5) vollflächig mit der Rückseite (3) des Chips (1) verbunden ist.

9. Halbleiter-Bauelement nach einem der Ansprüche 1 bis 7,
**dadurch gekennzeichnet, daß**
ein weiteres Kontaktelement (5) vorgesehen ist, welches großflächig mit der Rückseite (3) des Chips (1) verbunden ist und welches zumindest ein weiteres Anschlußelement (6) aufweist, das auf dem Träger (8) befestigbar ist.

10. Halbleiter-Bauelement nach einem der Ansprüche 1 bis 8,
**dadurch gekennzeichnet, daß**
zumindest ein weiterer Chip (1) vorgesehen ist, der eine Vorderseite (2) mit zumindest einem Chipanschluß hat, mit dem das Bauelement auf einem Träger (8) befestigbar ist, und der eine der Vorderseite (2) gegenüberliegende Rückseite (3) hat, wobei das Kontaktelement (5) großflächig mit der Rückseite (3) des weiteren Chips (1) verbunden ist.

11. Anordnung mit
- einem Träger (8),
- einem Chip (1), der eine Vorderseite (2) mit zumindest einem Chipanschluß hat, mit dem das Bauelement auf dem Träger (8) befestigt ist, wobei die Vorderseite (2) dem Träger (8) zugewandt ist, und der eine der Vorderseite (2) gegenüberliegende Rückseite (3) hat, und
- einem Kontaktelement (5), welches großflächig mit der Rückseite (3) des Chips (1) verbunden ist, und welches zumindest ein Anschlußelement (6) aufweist, das auf dem Träger (8) befestigt ist.

12. Anordnung nach Anspruch 11,
**dadurch gekennzeichnet, daß**
der Träger (8) eine Leiterplatte ist.
